# EUROPEAN PATENT APPLICATION

(11) **EP 4 793 657 A1**
(43) Date of publication of application: **19.08.2026**
(21) Application number: 25197261.8
(22) Date of filing: 21.08.2025
(51) Int. Cl.: G01S 7/481, H01S 5/042, G01S 7/484

(54) **LIGHT EMITTING DEVICE AND DISTANCE MEASURING APPARATUS**

(30) Priority: 12.02.2025 JP 2025020956
(71) Applicant: FUJIFILM Business Innovation Corp., Minato-ku Tokyo (JP)
(72) Inventor: KIMURA, Rio, Ebina-shi (JP); SAKAI, Kazuhiro, Ebina-shi (JP); OHSAWA, Chizuru, Ebina-shi (JP); TATEISHI, Naohiro, Yokohama-shi (JP); HAYAKAWA, Junichiro, Ebina-shi (JP); MATSUSHITA, Kazuyuki, Ebina-shi (JP)
(74) Representative: Haseltine Lake Kempner LLP

(57) **Abstract**

A light emitting device includes multiple drive circuits provided between a light source and a power supply; a selector that selects any one of the multiple drive circuits; a switch element included in each of the multiple drive circuits and connected to the light source; multiple resistors that are included in each of the multiple drive circuits, connected in parallel to each other, and adjust a current flowing through the corresponding switch element; and a resistance controller that switches at least one of the multiple resistors to a conductive state or a nonconductive state.

## Description

### Background

### (i) Technical Field

The technique of the present disclosure relates to a light emitting device and a distance measuring apparatus.

### (ii) Related Art

Even in a case of measuring the distance from a light emitting device to an object present at a certain distance, since the intensity of the reflected light changes in accordance with the reflectance of the object, Japanese Unexamined Patent Application Publication No. 2008-241435 discloses a technique of a light emitting element that changes the light amount of a modulation light source.

### Summary

To change the light amount of the modulation light source, for example, an expensive laser driver integrated circuit (IC), multiple light sources, and a drive circuit for each light source are generally provided. Thus, in the related art, the circuit configuration that adjusts the optical output may become complicated.

Accordingly, it is an object of the present disclosure to provide a light emitting device and a distance measuring apparatus that adjust the optical output with a simple configuration.

According to a first aspect of the present disclosure, there is provided a light emitting device including multiple drive circuits provided between a light source and a power supply; a selector that selects any one of the multiple drive circuits; a switch element included in each of the multiple drive circuits and connected to the light source; multiple resistors that are included in each of the multiple drive circuits, connected in parallel to each other, and adjust a current flowing through the corresponding switch element; and a resistance controller that switches at least one of the multiple resistors to a conductive state or a non-conductive state.

According to a second aspect of the present disclosure, there is provided the light emitting device according to the first aspect, further including a capacitor that is connected in parallel to the multiple resistors and operates in either state in which the resistors are in the conductive state or the non-conductive state.

According to a third aspect of the present disclosure, there is provided the light emitting device according to the second aspect, in which a light reception amount of light emitted from the light source and reflected by a detection object when a first drive circuit is selected from among the multiple drive circuits is larger than the light reception amount when a second drive circuit is selected from among the multiple drive circuits, and in which a capacitance of the capacitor included in the first drive circuit is larger than a capacitance of the capacitor included in the second drive circuit.

According to a fourth aspect of the present disclosure, there is provided the light emitting device according to the third aspect, in which the selector selects: when the light reception amount is equal to or more than a first threshold value, instead of the first drive circuit having a level of a signal for driving the switch element of a first value, the second drive circuit having the level of the signal of a second value that is lower than the first value, from among the multiple drive circuits; and selects the first drive circuit instead of the second drive circuit when the light reception amount is equal to or less than a second threshold value that is smaller than the first threshold value, and in which the resistance controller switches at least one of the multiple resistors to the conductive state or the non-conductive state so that an optical output of the light source falls within a specific range.

According to a fifth aspect of the present disclosure, there is provided the light emitting device according to the third aspect, in which the number of the multiple resistors connected in parallel to the capacitor included in the first drive circuit is smaller than the number of the multiple resistors connected in parallel to the capacitor included in the second drive circuit.

According to a sixth aspect of the present disclosure, there is provided the light emitting device according to the fourth aspect, in which the resistance controller decreases the number of the resistors in the conductive state when the optical output of the light source exceeds the specific range, and increases the number of the resistors in the conductive state when the optical output of the light source is below the specific range.

According to a seventh aspect of the present disclosure, there is provided a distance measuring apparatus including the light source; and the light emitting device according to any one of the first aspect to the sixth aspect.

According to the first aspect and the seventh aspect, by switching between conduction and non-conduction of the multiple resistors that adjust the current flowing through the switch element, it is possible to adjust the current in consideration of the variation in components of the device that is the switch element, and it is possible to suppress the variation in the optical output.

According to the second aspect, in addition to the effects of the first aspect and the seventh aspect, the waveform of the optical output can be adjusted.

According to the third aspect, it is possible to reduce the variation in the waveform of the optical output in the multiple drive circuits, compared to a case where the same capacitance is used in the multiple drive circuits.

According to the fourth aspect, since the resistance value of each of the multiple drive circuits can be finely adjusted, the variation in the optical output caused by the variation in components of the device included in each of the multiple drive circuits can fall within the specific range.

According to the fifth aspect, it is possible to adjust the gate voltage in accordance with the characteristics (gate-source voltage) of the device (switching element) included in each of the first drive circuit and the second drive circuit having different optical outputs while suppressing an increase in the number of the resistors.

According to the sixth aspect, since the number of the multiple resistors connected in parallel can be automatically changed in accordance with the optical output, it may be possible to easily suppress the variation in the optical output compared to a case where the values of the resistors are manually adjusted.

### Brief Description of the Drawings

An exemplary embodiment of the present disclosure will be described in detail based on the following figures, wherein:
Fig. 1 is a diagram illustrating a configuration example of a distance measuring apparatus according to an exemplary embodiment of the technique of the present disclosure;
Fig. 2 is a block diagram illustrating a hardware configuration of a selector;
Fig. 3 is a block diagram illustrating an example of a functional configuration of the selector;
Fig. 4 is a graph for explaining a function of the selector;
Fig. 5 is a block diagram illustrating a hardware configuration of a resistance controller;
Fig. 6 is a block diagram illustrating an example of a functional configuration of the resistance controller;
Fig. 7 is a table for explaining a function of the resistance controller;
Fig. 8 is a table for explaining the function of the resistance controller;
Fig. 9 is a graph for explaining the function of the resistance controller;
Fig. 10 is a graph for explaining the function of the resistance controller;
Fig. 11 is a diagram presenting an example of the waveform of a signal for driving one switch element or another switch element;
Fig. 12 is a diagram presenting an example of the waveform of the signal for driving the one switch element or the other switch element;
Fig. 13 is a diagram presenting an example of the waveform of the signal for driving the one switch element or the other switch element;
Fig. 14 is a flowchart for explaining a switching operation between one drive circuit and another drive circuit; and
Fig. 15 is a flowchart presenting a flow of a process performed by the resistance controller.

### Detailed Description

Hereinafter, an example of an exemplary embodiment of the technique of the present disclosure will be described with reference to the drawings. In the drawings, the same or equivalent components and portions are denoted by the same reference signs. In addition, the dimensional ratios in the drawings are exaggerated for the convenience of description, and may be different from the actual ratios.

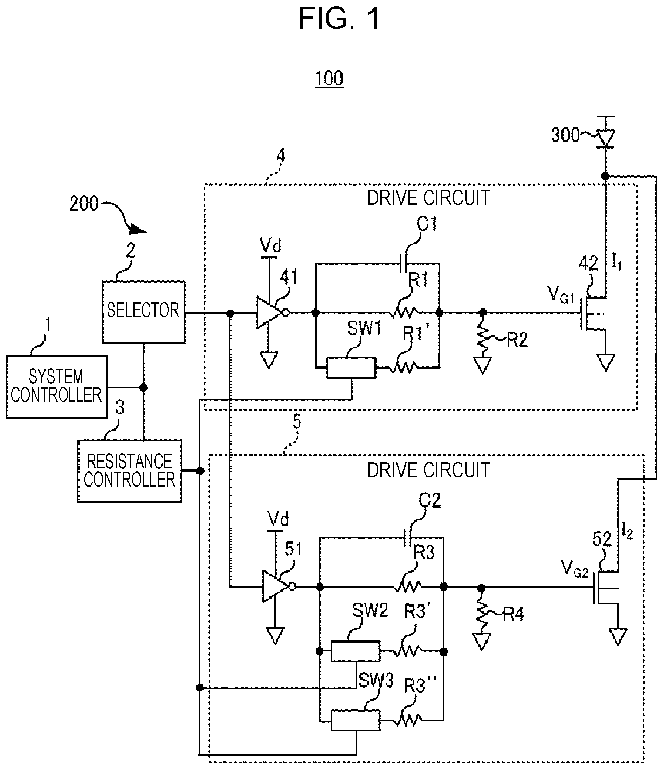

As illustrated in Fig. 1, a distance measuring apparatus 100 according to the exemplary embodiment of the technique of the present disclosure may include a light emitting device 200 and a light source 300 such as a vertical cavity surface emitting laser (VCSEL). The light emitting device 200 may include a system controller 1, a selector 2, a resistance controller 3, a drive circuit 4, and a drive circuit 5. The drive circuit 4 may be interpreted as a first drive circuit according to an exemplary embodiment of the present disclosure, and the drive circuit 5 may be interpreted as a second drive circuit according to an exemplary embodiment of the present disclosure.

The system controller 1 executes control by controlling the selector 2 to change the optical output in accordance with a change in the light reception amount of light emitted from the light source 300 and reflected by a detection object (measurement object) when the light reception amount changes in accordance with, for example, the distance to the measurement object, the absorbance of the measurement object, or the reflectance of the measurement object. The system controller 1 controls the resistance controller 3 to finely adjust the optical output so that the optical output that is output by the operation of each of the drive circuit 4 and the drive circuit 5 falls within a specific range. The drive circuit 4 is a circuit for generating a specific optical output, and the drive circuit 5 is a circuit for generating an optical output that is smaller than the optical output by the drive circuit 4.

The selector 2 selects one of the drive circuit 4 and the drive circuit 5. The configuration of the selector 2 will be described in detail later.

The resistance controller 3 controls a switch SW1, a switch SW2, and a switch SW3 to switch at least one of multiple resistors to a conductive state or a non-conductive state. Specifically, the resistance controller 3 switches at least one of the multiple resistors to the conductive state or the non-conductive state so that the optical output of the light source 300 falls within a specific range. The switch SW1, the switch SW2, and the switch SW3 are, for example, analog switches that each control on (close) and off (open) of an electric signal. The configuration of the resistance controller 3 will be described in detail later.

The drive circuit 4 includes an amplification circuit 41, a capacitor C1, a resistor R1, a resistor R1', the switch SW1, a resistor R2, and a switch element 42. The switch SW1 and the resistor R1' are connected in series. When the selector 2 selects the amplification circuit 41, the amplification circuit 41 boosts the voltage supplied from a power supply Vd and outputs the boosted voltage. One end of the capacitor C1 is connected to the output of the amplification circuit 41, and another end of the capacitor C1 is connected to the gate of the switch element 42. The resistor R1 is connected in parallel to the capacitor C1. The series-connected body of the switch SW1 and the resistor R1' is connected in parallel to the capacitor C1. One end of the resistor R2 is connected to the gate of the switch element 42, and another end of the resistor R2 is grounded. For example, the value of the capacitor C1 is 39 [pF], the value of the resistor R1 is 143 [Ω], and the value of the resistor R1' is 820 [Ω]. The combined resistance value of the resistor R1 and the resistor R1' is 120 [Ω]. The resistor R1 and the resistor R1' are connected in parallel to each other to adjust the current flowing through the switch element 42.

The capacitor C1 is a capacitor connected in parallel to the parallel-connected body of the resistor R1 and the resistor R1'. The capacitor C1 operates in either state in which the resistor R1 and the resistor R1' are in the conductive state or the non-conductive state. The waveform of a gate voltage V_{G1} may be adjusted using the values of the resistors and the capacitor C1 included in the drive circuit 4.

The switch element 42 is a semi-conductor switch such as a field-effect transistor (FET) or a metal oxide semiconductor field-effect transistor (MOSFET), and, for example, the gate is connected to the light source 300, the drain is connected to the capacitor C1, the resistor R1, the resistor R1', and the resistor R2, and the source is grounded. A drain current I₁ tends to increase as the level of a signal (gate voltage V_{G1}) for driving the switch element 42 rises. When the level of the signal (gate voltage V_{G1}) for driving the switch element 42 rises, the gate-source voltage of the switch element 42 rises, and the drain current I₁ increases. The level of the gate voltage V_{G1} is a first value.

The drive circuit 5 includes an amplification circuit 51, a capacitor C2, a resistor R3, a resistor R3', a resistor R3", the switch SW2, the switch SW3, a resistor R4, and a switch element 52. The switch SW2 and the resistor R3' are connected in series, and the switch SW3 and the resistor R3" are connected in series.

When the selector 2 selects the amplification circuit 51, the amplification circuit 51 boosts the voltage supplied from a power supply Vd and outputs the boosted voltage. One end of the capacitor C2 is connected to the output of the amplification circuit 51, and another end of the capacitor C2 is connected to the gate of the switch element 52. The resistor R3 is connected in parallel to the capacitor C2. The series-connected body of the switch SW2 and the resistor R3' is connected in parallel to the capacitor C2. The series-connected body of the switch SW3 and the resistor R3" is also connected in parallel to the capacitor C2.

One end of the resistor R4 is connected to the gate of the switch element 52, and another end of the resistor R4 is grounded. For example, the value of the capacitor C2 is 27 [pF], the value of the resistor R3 is 210 [Ω], the value of the resistor R3' is 2.8 [kΩ], and the value of the resistor R3" is 1.3 [kΩ]. The combined resistance value of the resistor R3 and the resistor R3' is 195 [Ω]. The combined resistance value of the resistor R3 and the resistor R3" is 203 [Ω]. The resistor R3, the resistor R3', and the resistor R3" are connected in parallel to one another to adjust the current flowing through the switch element 52.

The capacitor C2 is a capacitor connected in parallel to the resistor R3, the resistor R3', and the resistor R3". The capacitor C2 operates in either state in which the resistor R3, the resistor R3', and the resistor R3" are in the conductive state or the non-conductive state. The waveform of a gate voltage V_{G2} may be adjusted using the values of the resistors and the capacitor C2 included in the drive circuit 5.

Like the switch element 42, the switch element 52 is a semi-conductor switch such as a FET or a MOSFET, and, for example, the gate is connected to the light source 300, the drain is connected to the capacitor C2, the resistor R3, the resistor R3', the resistor R3", and the resistor R4, and the source is grounded. When the level of a signal (gate voltage V_{G2}) for driving the switch element 52 rises, the gate-source voltage of the switch element 52 rises, and a drain current I₂ increases. The level of the gate voltage V_{G2} is a second value that is lower than the first value that is the level of the gate voltage V_{G1}.

The number of the multiple resistors included in the drive circuit 4 and connected in parallel to the capacitor C1 may be smaller than the number of the multiple resistors included in the drive circuit 5 and connected in parallel to the capacitor C2. Accordingly, it may be possible to adjust the gate voltages (V_{G1}, V_{G2}) in accordance with the characteristics (gate-source voltages) of the devices (switch elements 42, 52) of the drive circuit 4 and the drive circuit 5 having different optical outputs while suppressing an increase in the number of the resistors, and thus the circuit configuration is simplified.

The light reception amount of light emitted from the light source 300 and reflected by the detection object when the drive circuit 4 is selected is larger than the light reception amount when the drive circuit 5 is selected, and the capacitance of the capacitor C1 included in the drive circuit 4 is larger than the capacitance of the capacitor C2 included in the drive circuit 5. Accordingly, it may be possible to reduce the variation in the waveform of the optical output in each of the drive circuits 4 and 5, compared to a case where the same capacitance is used in the drive circuits 4 and 5.

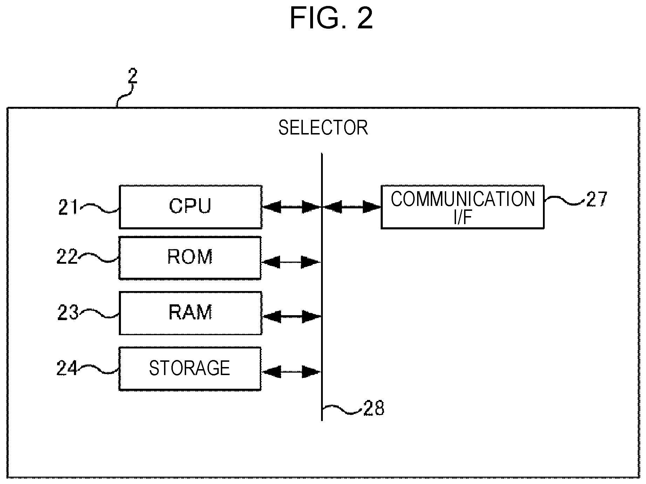

Next, a configuration example of the selector 2 will be described with reference to Figs. 2 to 4. As illustrated in Fig. 2, the selector 2 includes a central processing unit (CPU) 21, a read only memory (ROM) 22, a random access memory (RAM) 23, a storage 24, and a communication interface (communication I/F) 27. The respective configurations are communicably connected to one another via a bus 28. The CPU 21 is a central processing unit, and executes various programs and controls each component. That is, the CPU 21 reads a program from the ROM 22 or the storage 24 and executes the program using the RAM 23 as a work area. The CPU 21 controls the amplification circuit 41 or the amplification circuit 51 in accordance with a program recorded in the ROM 22 or the storage 24. In the present exemplary embodiment, a specific program for controlling the amplification circuit 41 or the amplification circuit 51 is stored in the ROM 22 or the storage 24. The ROM 22 stores various programs and various types of data. The RAM 23 serves as a work area for temporarily storing a program or data. The storage 24 is constituted by a hard disk drive (HDD) or a solid state drive (SSD), and stores various programs including an operating system, and various types of data. The communication interface 27 is an interface for communicating with, for example, the system controller 1.

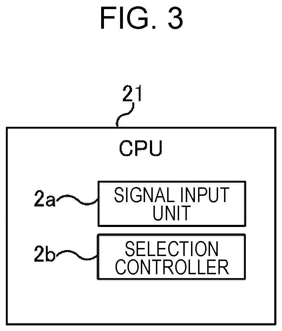

As illustrated in Fig. 3, the CPU 21 of the selector 2 includes a signal input unit 2a and a selection controller 2b. Each functional configuration is implemented by the CPU 21 reading a specific program stored in the ROM 22 or the storage 24, and loading and executing the specific program in the RAM 23.

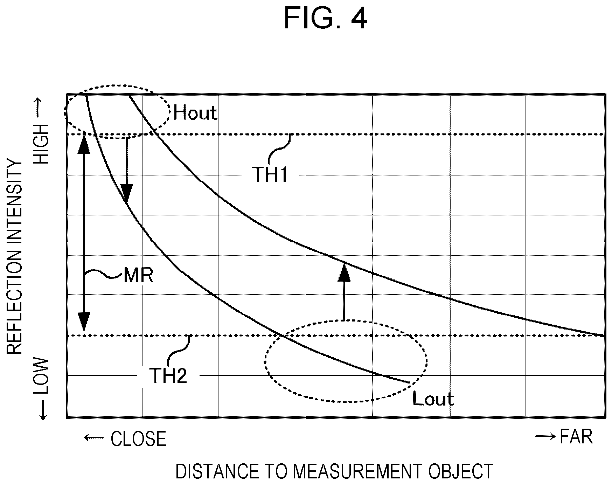

Fig. 4 is a graph for explaining a function of the selector 2. In Fig. 4, the vertical axis represents the reflection intensity, and the horizontal axis represents the distance to the measurement object. As presented in Fig. 4, when the reflection intensity is high and the light reception amount indicates a value Hout that is equal to or more than a first threshold value TH1, the signal input unit 2a receives a signal indicating that the light reception amount is equal to or more than the first threshold value TH1 from the system controller 1. In this case, to decrease the optical output, the selection controller 2b outputs a signal for selecting the amplification circuit 51 in the drive circuit 5 instead of the amplification circuit 41 in the drive circuit 4, that is, a signal for operating the amplification circuit 51.

In contrast, when the reflection intensity is low and the light reception amount indicates a value Lout that is equal to or less than a second threshold value TH2 that is less than the first threshold value TH1, the signal input unit 2a receives a signal indicating that the light reception amount is equal to or less than the second threshold value TH2 from the system controller 1. In this case, to increase the optical output, the selection controller 2b outputs a signal for selecting the amplification circuit 41 in the drive circuit 4 instead of the amplification circuit 51 in the drive circuit 5, that is, a signal for operating the amplification circuit 41.

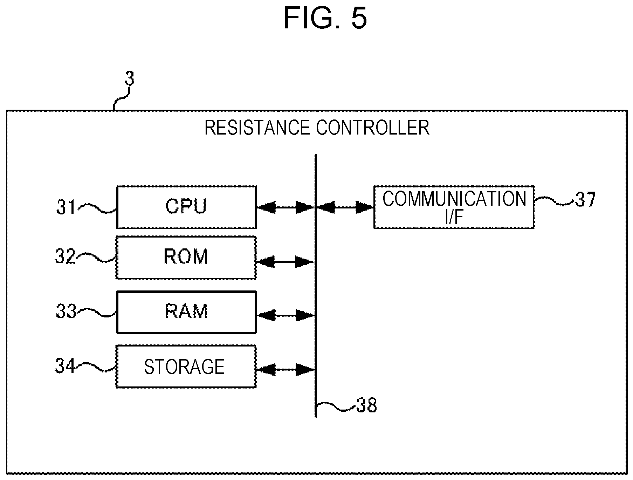

Next, a configuration example of the resistance controller 3 will be described with reference to Figs. 5 to 10. As illustrated in Fig. 5, the resistance controller 3 includes configurations of a CPU 31, a ROM 32, a RAM 33, a storage 34, and a communication interface 37. The respective configurations are communicably connected to one another via a bus 38. The CPU 31 is a central processing unit, and executes various programs and controls each component. That is, the CPU 31 reads a program from the ROM 32 or the storage 34 and executes the program using the RAM 33 as a work area. The CPU 31 controls the switch SW1, the switch SW2, and the switch SW3 according to a program recorded in the ROM 32 or the storage 34. In the present exemplary embodiment, the ROM 32 or the storage 34 stores a specific program for controlling the switch SW1, the switch SW2, and the switch SW3. The ROM 32 stores various programs and various types of data. The RAM 33 serves as a work area for temporarily storing a program or data. The storage 34 is constituted by a HDD or a SSD, and stores various programs including an operating system, and various types of data. The communication interface 37 is an interface for communicating with, for example, the system controller 1.

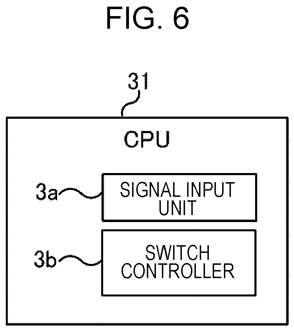

As illustrated in Fig. 6, the CPU 31 of the resistance controller 3 includes a signal input unit 3a and a switch controller 3b. Each functional configuration is implemented by the CPU 31 reading a specific program stored in the ROM 32 or the storage 34, and loading and executing the specific program in the RAM 33.

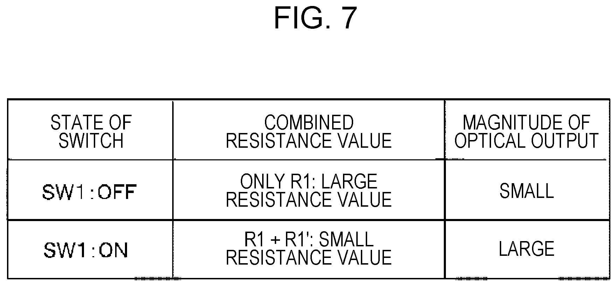

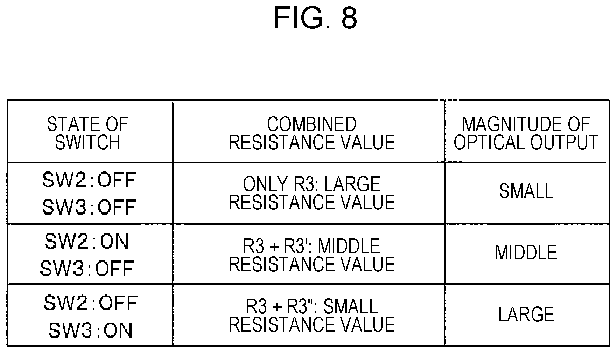

Figs. 7 and 8 are tables for explaining a function of the resistance controller 3. Fig. 7 presents the state of the switch SW1 controlled by the resistance controller 3, the combined resistance value in the drive circuit 4 according to the state of the switch SW1, and the magnitude of the optical output according to the combined resistance value. Fig. 8 presents the states of the switch SW2 and the switch SW3 controlled by the resistance controller 3, the combined resistance value in the drive circuit 5 according to the states of these switches, and the magnitude of the optical output according to the combined resistance value.

### Example of Resistance Control in Drive Circuit 4

For example, when the signal input unit 3a receives a signal indicating that the resistor R1' is to be brought into the non-conductive state, the switch controller 3b turns off the switch SW1 connected in series to the resistor R1' based on the signal.

When the signal input unit 3a receives a signal indicating that the resistor R1' is to be brought into the conductive state, the switch controller 3b turns on the switch SW1 based on the signal.

Since the combined resistance value when the resistor R1 and the resistor R1' are connected in parallel is smaller than the resistance value in the case of only the resistor R1, the level of the gate voltage V_{G1} when the switch SW1 is on is higher than the level of the gate voltage V_{G1} when the switch SW1 is off. Thus, the optical output when the switch SW1 is on is larger than the optical output when the switch SW1 is off.

### Example of Resistance Control in Drive Circuit 5

For example, when the signal input unit 3a receives a signal indicating that the resistor R3' and the resistor R3" are to be brought into the non-conductive state, the switch controller 3b turns off the switch SW2 connected in series to the resistor R3' and turns off the switch SW3 connected in series to the resistor R3" based on the signal.

When the signal input unit 3a receives a signal indicating that the resistor R3' is to be brought into the conductive state and the resistor R3" is to be brought into the non-conductive state, the switch controller 3b turns on the switch SW2 and turns off the switch SW3 based on the signal.

When the signal input unit 3a receives a signal indicating that the resistor R3' is to be brought into the non-conductive state and the resistor R3" is to be brought into the conductive state, the switch controller 3b turns off the switch SW2 and turns on the switch SW3 based on the signal.

When the signal input unit 3a receives a signal indicating that the resistor R3' and the resistor R3" are to be brought into the conductive state, the switch controller 3b may turn on the switch SW2 and the switch SW3 based on the signal.

The combined resistance value when the resistor R3 and the resistor R3' are connected in parallel is smaller than the resistance value in the case of only the resistor R3. Accordingly, the level of the gate voltage V_{G2} when the switch SW2 is on and the switch SW3 is off is higher than the level of the gate voltage V_{G2} when both the switch SW2 and the switch SW3 are off. Thus, the optical output when the switch SW2 is on and the switch SW3 is off is larger than the optical output when both the switch SW2 and the switch SW3 are off.

The combined resistance value when the resistor R3 and the resistor R3" are connected in parallel is smaller than the combined resistance value when the resistor R3 and the resistor R3' are connected in parallel. Accordingly, the level of the gate voltage V_{G2} when the switch SW2 is off and the switch SW3 is on is higher than the level of the gate voltage V_{G2} when the switch SW2 is on and the switch SW3 is off. Thus, the optical output when the switch SW2 is off and the switch SW3 is on is larger than the optical output when the switch SW2 is on and the switch SW3 is off.

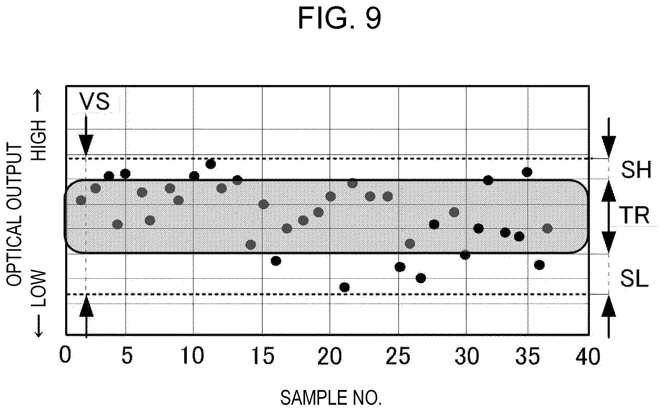

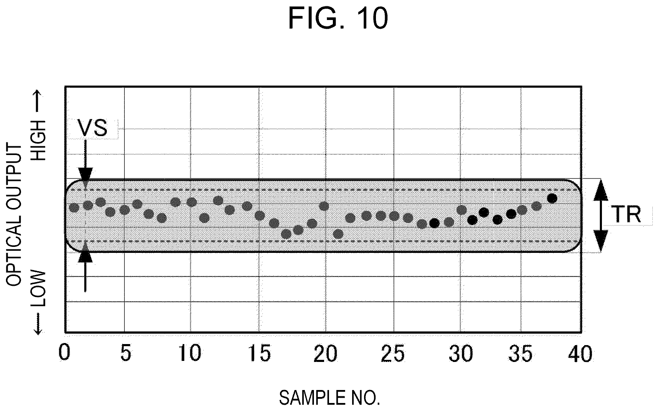

By controlling the resistance value as described above, it may be possible to adjust the current in consideration of the variation in components of the switch elements 42 and 52 (devices), and it may be possible to suppress the variation in the optical output. Figs. 9 and 10 present the optical output of the light emitting device 200 using, for example, each of 37 samples (switch elements 42 and 52). The vertical axis of each graph represents the optical output, and the horizontal axis of each graph represents the sample number. As presented in Fig. 9, there is a variation in the optical output when each sample is used, and a range VS of the variation exceeds a range (target range TR) of ideal optical output.

In the resistance control according to the exemplary embodiment of the present disclosure, by finely adjusting the levels of the respective gate voltages V_{G1} and V_{G2} of the drive circuit 4 and the drive circuit 5, the optical outputs when a sample SH that is higher than the target range TR and a sample SL that is lower than the target range TR are used may fall within the target range TR as presented in Fig. 10. The resistance control according to the exemplary embodiment of the present disclosure may be performed at the time of shipment of the light emitting device 200, or may be performed during operation of the light emitting device 200. For example, even when the level of the optical output changes outside the target range TR due to the change in the operating points of the switch element 42 and the switch element 52 caused by the heat generation of the light emitting device 200 itself or the heat from the surroundings of the light emitting device 200, the optical output may fall within the target range TR by performing the resistance control according to the exemplary embodiment of the present disclosure.

For example, in a case where the optical output when the drive circuit 4 is operated is larger than (exceeds) the target range TR, the system controller 1 outputs the signal indicating that the resistor R1' is to be brought into the non-conductive state, so that the switch SW1 is turned off, and the level of the gate voltage V_{G1} is lowered, that is, the optical output is decreased. Accordingly, the optical output may fall within the target range TR as presented in Fig. 10.

When the optical output when the drive circuit 4 is operated is smaller than (below) the target range TR, the system controller 1 outputs the signal indicating that the resistor R1' is to be brought into the conductive state, so that the switch SW1 is turned on, and the level of the gate voltage V_{G1} is increased due to the combined resistance value of the resistor R and the resistor R1', that is, the optical output is increased. Accordingly, the optical output may fall within the target range TR as presented in Fig. 10.

The optical output of the drive circuit 5 during operation may be controlled likewise. As described above, when the optical output of the light source 300 exceeds the specific range, the resistance controller 3 decreases the number of the resistors in the conductive state so that the optical output of the light source 300 falls within the specific range (target range TR), and when the optical output of the light source 300 is below the specific range, the resistance controller 3 increases the number of the resistors in the conductive state so that the optical output of the light source 300 falls within the specific range. By automatically changing the number of the multiple resistors connected in parallel in accordance with the optical output, it may be possible to easily suppress the variation in the optical output compared to a case where the values of the resistors are manually adjusted. Further, the adjustment range of the optical output may be widened with a simple configuration.

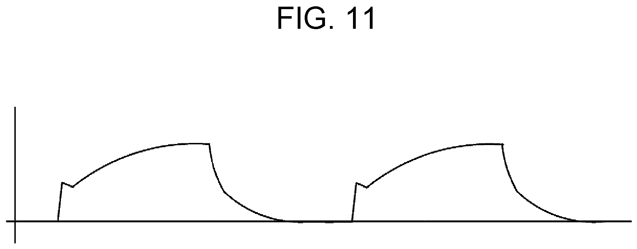

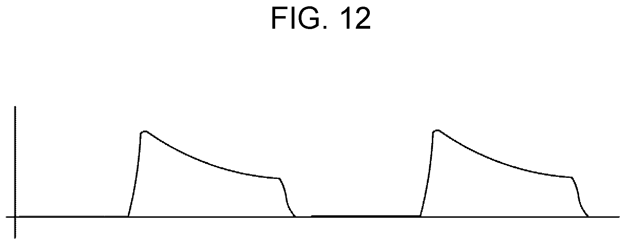

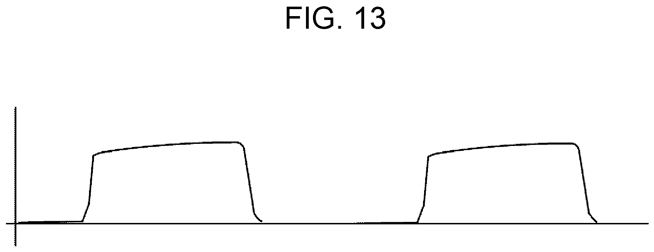

Figs. 11 to 13 are diagrams illustrating examples of the waveform of the signal for driving the switch element 42 or the switch element 52. When the capacitor (C1, C2) is not provided, the rising of the signal is rounded like an arc, but when the capacitor is provided, the rising of the waveform of the signal becomes sharp. Fig. 11 presents the waveform of the gate voltage (V_{G1}, V_{G2}) that rises slowly because the value is smaller than an appropriate value and hence the resistance-capacitance (RC) time constant decreases although the capacitor (C1, C2) is provided. Fig. 12 presents the waveform of the gate voltage (V_{G1}, V_{G2}) in a case where the rising is accelerated because the value of the capacitor (C1, C2) is larger than the appropriate value and hence the RC time constant increases, but the difference in the values between the first half and the second half of the waveform is large. Fig. 13 presents the waveform of the gate voltage (V_{G1}, V_{G2}) when the value of the capacitor (C1, C2) is set to the appropriate value.

Since the level of the gate voltage V_{G1} of the drive circuit 4 with large optical output is higher than the level of the gate voltage V_{G1} of the drive circuit 5 with small optical output, the charge to be added to the gate capacitance may be set to an appropriate value in accordance with the level of the gate voltage V_{G1} by setting the capacitance of the capacitor C1 to be larger than the capacitance of the capacitor C2. Thus, compared to a case where the drive circuit 4 and the drive circuit 5 use the capacitances of the same value, the variation in the waveform of the optical output in each of the drive circuit 4 and the drive circuit 5 may be reduced.

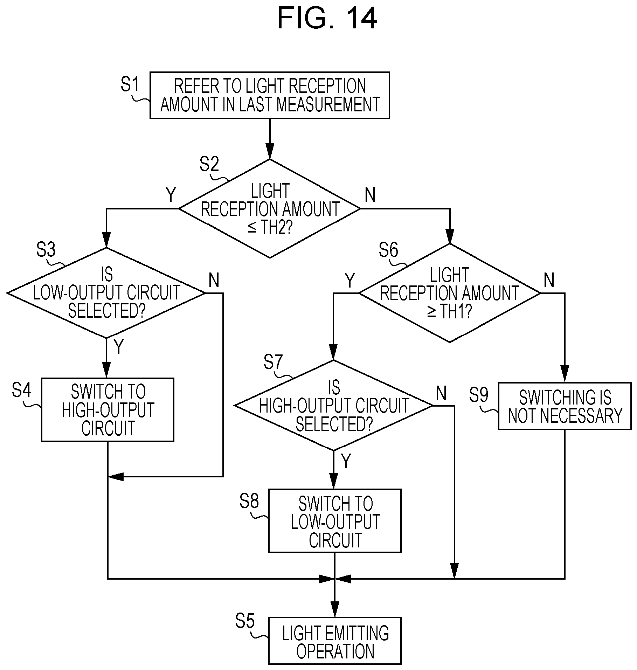

Next, the operation of the light emitting device 200 will be described. Fig. 14 is a flowchart for explaining a switching operation between the drive circuit 4 and the drive circuit 5.

In step S1, the system controller 1 refers to the light reception amount in the last measurement, and when the light reception amount is equal to or less than the second threshold value TH2 in step S2, the system controller 1 executes the processing of step S3.

When the low-output drive circuit 5 is selected in step S3, in step S4, the system controller 1 outputs the signal indicating that the light reception amount is equal to or less than the second threshold value TH2, and the selector 2 that has received the signal switches the drive circuit to the high-output drive circuit 4, and, in step S5, a light emitting operation of the drive circuit 4 is performed.

When the high-output drive circuit 4 is selected in step S3, the system controller 1 does not output the signal indicating that the light reception amount is equal to or less than the second threshold value TH2, and, in step S5, the light emitting operation of the drive circuit 4 is continued.

When the light reception amount exceeds the second threshold value TH2 in step S2, the system controller 1 executes the processing of step S6. When the light reception amount is equal to or more than the first threshold value TH1 in step S6, the system controller 1 executes the processing of step S7.

When the high-output drive circuit 4 is selected in step S7, in step S8, the system controller 1 outputs the signal indicating that the light reception amount is equal to or more than the first threshold value TH1, and the selector 2 that has received the signal switches the drive circuit to the low-output drive circuit 5, and, in step S5, the light emitting operation of the drive circuit 5 is performed.

When the low-output drive circuit 5 is selected in step S7, the system controller 1 does not output the signal indicating that the light reception amount is equal to or less than the second threshold value TH2, and, in step S5, the light emitting operation of the drive circuit 5 is continued.

When the light reception amount is less than the first threshold value TH1 in step S6, in step S9, the system controller 1 does not output the signal indicating that the light reception amount is equal to or more than the first threshold value TH1 or the signal indicating that the light reception amount is equal to or less than the second threshold value TH2. Accordingly, the selector 2 determines that the switching between the drive circuits 4 and 5 is not necessary, and, in step S5, the light emitting operation of the selected drive circuit 4 or 5 is continued.

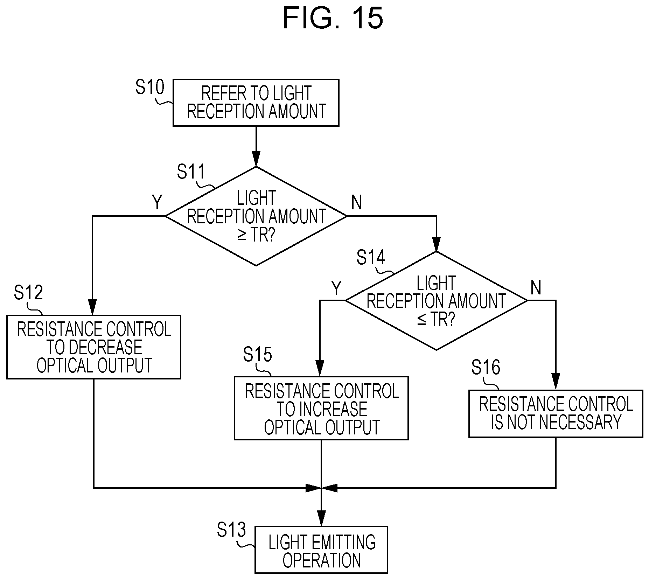

Fig. 15 is a flowchart presenting a flow of a process performed by the resistance controller 3. In step S10, the system controller 1 refers to the light reception amount in the last measurement, and when the light reception amount is equal to or more than the target range TR in step S11, the system controller 1 executes the processing of step S12.

In step S12, the system controller 1 outputs the signal indicating that the resistor is to be brought into the non-conductive state or the conductive state so that the light reception amount falls within the target range TR. Accordingly, the resistance controller 3 controls the number of the multiple resistors connected in parallel so that the optical output falls within the target range TR. Thus, in step S13, the optical output of the selected drive circuit 4 or 5 is adjusted, and the light emitting operation is performed with the adjusted optical output.

When the light reception amount is not more than the target range TR in step S11, the processing of step S14 is executed. In step S14, when the light reception amount is less than the target range TR, the system controller 1 executes the processing of step S15.

In step S15, the system controller 1 outputs the signal indicating that the resistor is to be brought into the non-conductive state or the conductive state so that the light reception amount falls within the target range TR. Accordingly, the resistance controller 3 controls the number of the multiple resistors connected in parallel so that the optical output falls within the target range TR. Thus, in step S13, the optical output of the selected drive circuit 4 or 5 is adjusted, and the light emitting operation is performed with the adjusted optical output.

When the light reception amount is not less than the target range TR in step S14, the system controller 1 executes the processing of step S16. In step S16, the system controller 1 does not output the signal indicating that the resistor is to be brought into the non-conductive state or the conductive state, and thus the resistance controller 3 determines that the resistance control is not necessary, and, in step S13, the light emitting operation is performed with the optical output of the selected drive circuit 4 or 5.

As described above, the light emitting device 200 according to the exemplary embodiment of the present disclosure includes the selector 2 that selects one of the multiple drive circuits 4 and 5, and the resistance controller 3 that switches at least one of the multiple resistors to the conductive state or the non-conductive state. With this configuration, it may be possible to suppress the variation in the optical output in consideration of the variation in components of the device while changing the optical output in accordance with, for example, the distance of the measurement object, or the absorbance or the reflectance of the object, and thus it may be possible to widen the adjustment range of the optical output with a simple configuration.

In the exemplary embodiments, the processes are performed by any computer. The computer may perform the processes by using a processor serving as hardware, a program serving as software, or combination of these. In this case, the processor is configured to perform the processes in the exemplary embodiments in cooperation with the program and may function as a unit or a means in the exemplary embodiments. The order in which the processor performs the processes is not limited to the described order and may be changed appropriately. The computer may be a general-purpose computer, an application specific computer, a workstation, or another system capable of performing the processes.

The processor may be composed of one or more pieces of hardware, and the type of the hardware is not limited. For example, the processor may be composed of hardware such as a central processing unit (CPU), a micro processing unit (MPU), a programmable logic device such as a field programmable gate array (FPGA), a dedicated circuit for performing specific processing such as an application specific integrated circuit (ASIC), a graphics processing unit (GPU), or a neural processing unit (NPU). Regarding the type of the hardware, different types of hardware may be combined. If multiple pieces of hardware are configured to perform one or more processes of the processor, the multiple pieces of hardware may be present in apparatuses physically away from each other or may be present in one apparatus. In each of exemplary embodiments, the order in which the processor performs the processes is not limited to the order described above and may be changed appropriately. The hardware is composed of electric circuitry in which circuit elements such as semiconductor devices are combined, or the like.

Further, the program may be software such as firmware or microcode. The program may be, for example, a program module group, and the functions thereof may be implemented by processors configured to implement the respective functions. The program may be program code or multiple code segments stored in one or more non-transitory computer readable media (for example, a storage medium or another storage). The program may be stored in such a divided manner in multiple non-transitory computer readable media present in apparatuses physically away from each other. The program code or the code segments may represent a procedure, a function, a sub program, a routine, a subroutine, a module, a software package, a class or any combination of instructions, data structures, or program statements. The program code or the code segment may be connected to another code segment or a hardware circuit by transmitting and/or receiving information, data, an argument, a parameter, or memory content. The program according to this application may be provided as a program product.

The foregoing description of the exemplary embodiments of the present disclosure has been provided for the purposes of illustration and description. It is not intended to be exhaustive or to limit the disclosure to the precise forms disclosed. Obviously, many modifications and variations will be apparent to practitioners skilled in the art. The embodiments were chosen and described in order to best explain the principles of the disclosure and its practical applications, thereby enabling others skilled in the art to understand the disclosure for various embodiments and with the various modifications as are suited to the particular use contemplated. It is intended that the scope of the disclosure be defined by the following claims and their equivalents.

## Claims

1. A light emitting device comprising:
a plurality of drive circuits provided between a light source and a power supply;
a selector that selects any one of the plurality of drive circuits;
a switch element included in each of the plurality of drive circuits and connected to the light source;
a plurality of resistors that are included in each of the plurality of drive circuits, connected in parallel to each other, and adjust a current flowing through the corresponding switch element; and
a resistance controller that switches at least one of the plurality of resistors to a conductive state or a non-conductive state.

2. The light emitting device according to claim 1, further comprising a capacitor that is connected in parallel to the plurality of resistors and operates in either state in which the resistors are in the conductive state or the non-conductive state.

3. The light emitting device according to claim 2,
wherein a light reception amount of light emitted from the light source and reflected by a detection object when a first drive circuit is selected from among the plurality of drive circuits is larger than the light reception amount when a second drive circuit is selected from among the plurality of drive circuits, and
wherein a capacitance of the capacitor included in the first drive circuit is larger than a capacitance of the capacitor included in the second drive circuit.

4. The light emitting device according to claim 3,
wherein the selector:
selects, when the light reception amount is equal to or more than a first threshold value, instead of the first drive circuit having a level of a signal for driving the switch element of a first value, the second drive circuit having the level of the signal of a second value that is lower than the first value, from among the plurality of drive circuits; and
selects the first drive circuit instead of the second drive circuit when the light reception amount is equal to or less than a second threshold value that is smaller than the first threshold value, and
wherein the resistance controller switches at least one of the plurality of resistors to the conductive state or the non-conductive state so that an optical output of the light source falls within a specific range.

5. The light emitting device according to claim 3, wherein the number of the plurality of resistors connected in parallel to the capacitor included in the first drive circuit is smaller than the number of the plurality of resistors connected in parallel to the capacitor included in the second drive circuit.

6. The light emitting device according to claim 4,
wherein the resistance controller:
decreases the number of the resistors in the conductive state when the optical output of the light source exceeds the specific range; and
increases the number of the resistors in the conductive state when the optical output of the light source is below the specific range.

7. A distance measuring apparatus comprising:
the light source; and
the light emitting device according to any one of claims 1 to 6.
